# EUROPEAN PATENT SPECIFICATION

(11) **EP 4 415 006 B1**
(45) Date of publication and mention of the grant of the patent: **10.09.2025**
(21) Application number: 23156259.6
(22) Date of filing: 13.02.2023
(51) Int. Cl.: H01F 27/02, F04F 5/16, F04F 5/46, F04D 25/08, H01F 27/12

(54) **AN AIRFLOW GENERATOR**
LUFTSTROMERZEUGER
GÉNÉRATEUR DE FLUX D'AIR

(43) Date of publication of application: 14.08.2024
(73) Proprietor: Hitachi Energy Ltd, 8050 Zürich (CH)
(72) Inventor: BEL FDHILA, Rebei, 724 76 Västerås (SE); HOSAIN, Lokman, 724 79 Västerås (SE); SAND, Ulf, 723 56 Västerås (SE)
(74) Representative: Valea AB

(56) References cited:
- US-A1- 2017 057 621
- US-A1- 2019 277 317

## Description

### TECHNICAL FIELD

The present disclosure relates to an airflow generator, and to a transformer assembly comprising such an airflow generator for cooling of a heat exchanger provided externally of the transformer for cooling of the transformer.

### BACKGROUND OF THE INVENTION

A power transformer is equipment used in an electric grid of a power system. Power transformers transform voltage and current in order to transport and distribute electric energy. Power transformers involve high currents; therefore, production of heat is inevitable. This heat propagates in oil inside a transformer tank. It is important to release this heat to the surroundings for the normal operation of transformers. An important part of oil-cooling is carried out by placing external devices by the transformer, such as radiators, cooler banks etc., through which the transformer oil is circulated and get cooled. State-of-the art air-cooling for a transformer is performed using conventional fans, i.e., bladed fans, or using natural convection. The state-of-the-art cooling systems using bladed fans typically produce high noise, have complex structure, are heavy, and are difficult to maintain. For high-power transformers, natural convection is not enough to cool the transformer, and therefore, forced cooling is needed.

External transformer cooling generally uses a one or more radiators external to the transformer, said radiators allowing oil to circulate from the transformer and out to the radiators, where heat is dissipated from the oil to surrounding ambient air. The cooling process uses typically uses natural convection or forced convection to move ambient air past the radiator.

US 2017/057621 shows a nesting of Coanda-effect air multipliers that increase the airflow within the multiplier. US 2019/277317 shows angled and staggered Coanda-effect air multipliers.

This disclosure concerns cooling systems using forced convection. Forced convection is typically achieved using one or more large fans blowing air through or onto the radiator(s). Cooling efficiency is dependent on airflow rate and consequently on the power consumption of the fans.

Accordingly, an object of the present disclosure is to provide a compact and power-efficient airflow generator cooling arrangement for a transformer.

### SUMMARY OF THE INVENTION

According to a first aspect of the present disclosure, these and other objects are achieved by an airflow generator as defined in claim 1, with alternative embodiments defined in dependent claims. The airflow generator is suitable for cooling an oil-to-air external heat exchanger of a transformer. The airflow generator comprises an electrically powered ducted fan provided with an inlet and an outlet, a fluid conduit; and a plurality of air multipliers for discharging air along a first axis, each air multiplier comprising an inlet and an outlet. The fluid conduit fluidly connecting the outlet of the ducted fan to the inlets of the air multipliers. The air multipliers are differently sized to provide airflows of different cross-sectional size and are positioned such that smaller ones of the air multipliers provide airflows reinforcing a respective sub-portion of the airflows provided by larger air multipliers. Further, the air multipliers are distributed along the first axis.

The fan provides an airflow into the air multiplier. The ducted nature of the fan enables it to efficiently pressurize the fluid conduit. By providing the airflow generator with an air multiplier, a much larger amount of air than the amount of air supplied by the fan, is discharged towards the oil-to-air heat exchanger. This reduces power-consumption as compared to use of conventional fans directly blowing air against the oil-to-air heat exchanger. Also, noise emitted from the fan and air multiplier combination is lower than a corresponding noise level emitted from a fan achieving the same airflow towards the heat exchanger.

Prior art air multipliers are often configured as rings with a central opening though which air is moved along by air discharged from the air multiplier. The flow velocity of air flowing through the ring is higher closer to the ring and lower further from the ring.

By providing the airflow generator with multiple air multipliers of different size, as claimed, the airflow generator device discharges air over a larger portion of the cross-section of the airflow provided by the largest air multiplier, thereby enabling improved control over the flow velocity across the whole cross-section of the airflow of the largest air multiplier.

Since each air multiplier has a certain size, adding additional air multipliers inside the largest air multiplier, in the same plane as the larger air multiplier, would restrict the area available for fluid flow through the largest air multiplier. By distributing the air multipliers along the first axis, flow restrictions are avoided, in turn leading to improved energy efficiency of the airflow generator. Local airflow rates are generally more evenly distributed further away from the air multiplier. The herein disclosed airflow generator provides a more even distribution of airflow rated closer to the airflow generator, thereby allowing the airflow generator to be positioned closer to an object to be cooled by the airflow. This enables a reduction of the size of a product incorporating the airflow generator for cooling of the product.

The airflow generator may further comprise support means configured to carry the air multipliers, said support means being configured such that at least some of the air multipliers are movable along the first axis.

The movability of the air multipliers enables the air multipliers to be moved together to reduce the overall size of the airflow generator, thereby enabling easier storage and transport. The movability of the air multipliers also enables the air multipliers to be moved apart along the first axis upon installation, and/or to adjust the performance of the airflow generator, for example to cater for different spacing of the air multipliers based on intended airflow rate of the ducted fan.

The support means may comprise one or more electrically powered actuators configured to control movement of one or more of the air multipliers along the first axis.

The provision of the electrically powered actuator enables electronic control of the relative positions of the air multipliers, thereby enabling easier adjustability of the spacing between the air multipliers along the first axis. The electronic control enables remote control, and/or automated control of the positions of the air multipliers.

The air multipliers may be configured such that a discharge direction of each air multiplier is parallel to the first axis.

By configuring the air multipliers such that the discharge direction of each air multiplier is parallel, to the first axis, all air multipliers blow in a same direction and thus contribute to accelerating air along the first axis in an energy-efficient manner.

The air multipliers are sometimes referred to as Coanda effect air multipliers. Each air multiplier may form a closed loop.

The closed-loop air multipliers have no free ends and are thus robust. Further, by avoiding free ends of the air multiplier, turbulence around the free ends is avoided.

The closed loops may be circular.

The circular shape of the air multiplier enables it to provide a same airflow independently of the rotational orientation of the airflow generator about the first axis, thereby simplifying access to the airflow multiplier where limited space is available around an object towards which the airflow of the airflow generator is to be directed.

The outlet of each air multiplier may extend around at least 90% of a circumference of the air multiplier about the first axis, such as around 100% of the circumference.

A greater extent of the outlet of each air multiplier enables improved control of the output of air from the air multiplier around the first axis, thereby promoting improved control of the airflow created by the airflow generator.

The fluid conduit may be connected to one of the air multipliers, wherein the air multipliers are fluidly interconnected by means of one or more additional fluid conduits.

By interconnecting the air multipliers by additional fluid conduits, only one fluid conduit is needed from the ducted fan, thereby simplifying the overall design and reducing weight, as compared to having one fluid conduit from each air multiplier to the ducted fan.

According to a second aspect of the present disclosure, these and other objects may be achieved by a transformer arrangement as defined in claim 10. The transformer arrangement comprises an airflow generator according to any one of the alternatives defined above, and a transformer provided with an oil-to-air external heat exchanger. The airflow generator is configured to discharge air towards the oil-to-air heat exchanger.

Transformers provided with oil-to-air heat exchangers are known. By providing such transformers with the claimed airflow generator, an energy efficient and compact cooling system for the transformer is achieved.

### BRIEF DESCRIPTION OF THE DRAWINGS

Fig. 1a shows a prior art airflow generator comprising an air multiplier.
Fig. 1b shows a side view of the prior art airflow generator also shown in fig. 1a (shown without the ducted fan and without the fluid conduit).
Fig. 2a shows another prior art airflow generator comprising a plurality of air multipliers concentrically aligned and arranged in a planar fashion.
Fig. 2b shows a side view of the prior art airflow generator also shown in fig. 2a (shown without the ducted fan and without the fluid conduit).
Fig. 3 shows a first embodiment of an airflow generator according to the present disclosure, provided with axially distributed air multipliers and a separate fluid conduit branch to each air multiplier.
Fig. 4 shows a first embodiment of an airflow generator according to the present disclosure, provided with axially distributed air multipliers, one fluid conduit to one of the air multipliers, and additional fluid conduits interconnecting the air multipliers.
Fig. 5 shows a perspective view of a cross-section of one of the air multipliers. All air multipliers are based on the same general cross-sectional design.
Fig. 6 shows a transformer arrangement comprising the airflow generator also shown in fig. 4, and a transformer provided with an external oil-to-air heat exchanger.

All figures are schematical illustrations and are not drawn to scale.

### DETAILED DESCRIPTION

Embodiments of the present disclosure will hereinafter be explained with reference to the appended drawings.

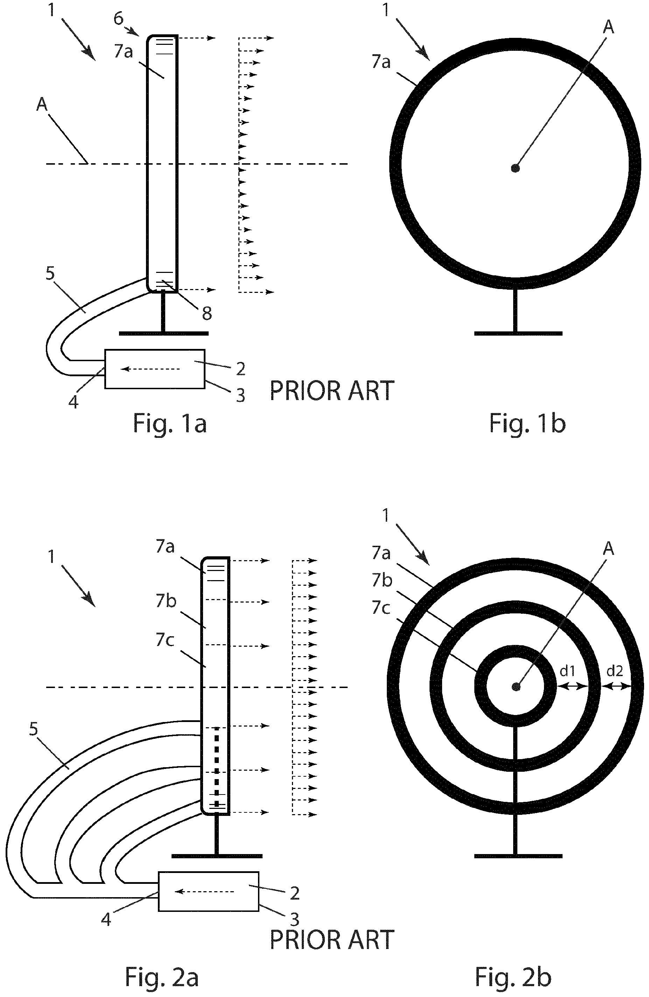

Fig. 1 shows a prior art airflow generator comprising an electrically powered ducted fan 2 provided with an inlet 3 and an outlet 4. The airflow generator 1 further comprises a fluid conduit 5 and an air multiplier 7a for discharging air along a first axis A. The air multiplier 7a comprises an inlet 8 and an outlet 9. The fluid conduit 5 fluidly connects the outlet 4 of the ducted fan 2 to the inlets 8 of the air multiplier 7a.

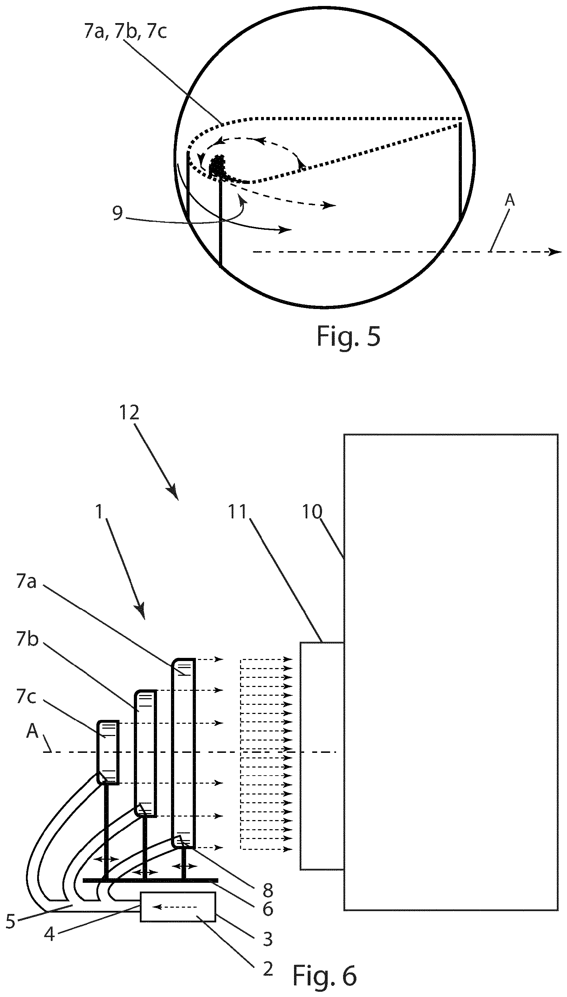

The term air multiplier is used in the prior art and thus should be known to the skilled person. Air multipliers are nozzles typically used in bladeless fans. Herein, the term air multiplier may to refer to any type of air discharge device/nozzle designed to discharge air through an outlet, typically in the form of one or more elongate slits, such that air around the discharge device is brought along by the air discharged from the outlet at a rate of at least 5-15 times the amount of air discharged by the outlet. Another term which could be used instead of air multiplier is Coand 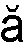 effect air flow multiplier. Such air discharge devices can vary greatly in design but are often shaped like an extruded hollow profile, an example of which is shown in fig. 5, although any other suitable shape is possible. The profile usually has an elongate cross-sectional shape, and the outlet is typically configured to discharge air in a direction along a longitudinal axis extending along the length of the elongate cross-sectional shape, as shown in fig. 5. The profile may have an aerodynamic foil shape. The outlet may be provided anywhere suitable along the length of the cross-sectional shape of the profile, such as at a leading portion of the profile (facing incoming ambient air as in fig. 5), or at a trailing portion of the profile, facing in the discharge direction of the air multiplier, or somewhere between the leading and trailing portions of the profile. The profile may be straight but is typically bent to form a ring circumscribing an inner cross-sectional area of the air multiplier.

The air multiplier may be provided with a convex wall portion wherein the outlet may be provided such that air is discharged adjacent the curved portion, along the curved portion, wherein the discharged air 'adheres' to the curved wall portion. This leads to increased suction effect acting on ambient air on the opposite side of the discharged airflow with respect to the curved wall portion.

In fig. 1b, the airflow generator 1 also shown in fig. 1a is shown without the ducted fan 2 and without the fluid conduit 5.

The fan 2 provides an airflow into the air multiplier 7a. The ducted nature of the fan 2 enables it to efficiently pressurize the fluid conduit 5. By providing the airflow generator 1 with an air multiplier 7a, a much larger amount of air than the amount of air supplied by the fan 2, is discharged towards the oil-to-air heat exchanger. Depending on the specific design of the air multiplier 7a, the airflow generator 1 may thus be able to output an airflow of ten to fifteen times the airflow produced by the fan 2. This reduces power-consumption as compared to use of conventional fans directly blowing air against an object to be cooled, such as an oil-to-air heat exchanger provided on a transformer.

Such air multipliers 7a are typically configured as rings with a central opening though which air is moved along by air discharged from the air multiplier along a first axis A. The flow velocity of air flowing through the ring is higher closer to the ring and lower further from the ring, as indicated by the broken-line arrows of fig. 1 whose length indicate a strength of local airflow.

Another embodiment of a prior art airflow generator is shown in figs. 2a and 2b. The airflow generator 1 of figs. 2a and 2b corresponds to the airflow generator 1 of fig. 1, but is provided with additional air multipliers 7b, 7c provided radially inside of the larger outer air multiplier 7a. The air multipliers 7a, 7b, 7c are arranged in a same plane as indicated in fig. 2a. As shown in fig. 2b, the total cross-sectional area inside the larger air multiplier 7a is limited by the thickness of the two inner air multipliers 7b, 7c, and only allows air to flow through the passages indicated by arrows d1 and d2. The additional inner air multipliers 7b, 7c provide increased airflow and improved control of airflow over the cross-sectional area inside the largest air multiplier 7a. However, the additional air multipliers 7b, 7c lead to reduced energy efficiency of the airflow generator 1.

To improve energy efficiency, the present disclosure proposes to axially displace the air multipliers 7a, 7b, 7c along the first axis A. This provides greater distance between the air multipliers 7a, 7b, 7c, thereby mitigating flow restrictions, which in turn leads to improved energy efficiency of the airflow generator 1.

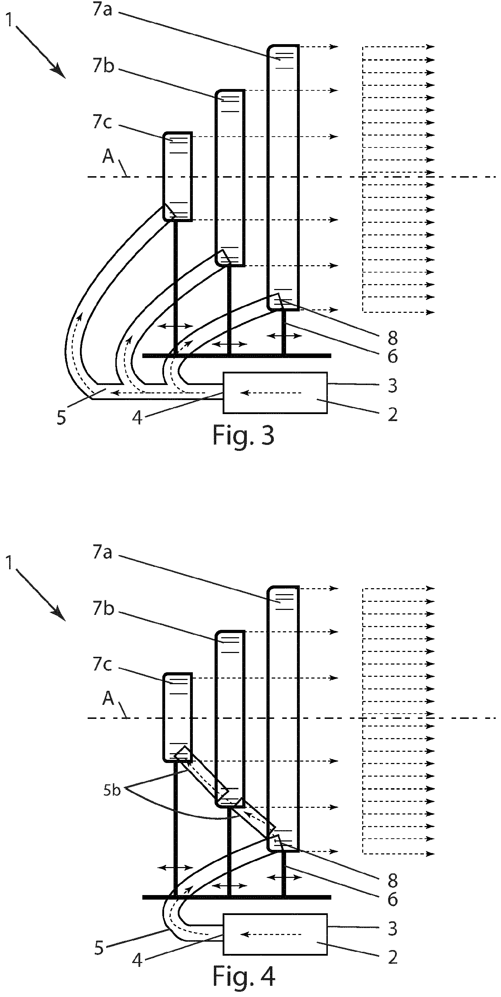

Embodiment of such an improved airflow generator is shown in figs. 3 and 4.

In the embodiments of figs. 3 and 4, the airflow generator 1 thus comprises multiple air multipliers 7a, 7b, 7c which are differently sized to provide airflows of different cross-sectional size, and are positioned such that smaller ones 7b, 7c of the air multipliers 7a, 7b, 7c provide airflows reinforcing a respective sub-portion of the airflows provided by larger air multipliers 7a, 7b. Also, the air multipliers 7a, 7b, 7c are distributed along the first axis A.

As shown in figs. 3 and 4, the airflow generator 1 further comprises support means 6 configured to carry the air multipliers 7a, 7b, 7c. The support means may be a separate supporting structure, or it may be configured in any other suitable way, such as a housing forming the ducting of the ducted fan, the fluid conduit from the ducted fan to the air multipliers 7a, 7b, 7c and also forming support for the air multipliers 7a, 7b, 7c.

Optionally, the support means 6 is configured such that at least some of the air multipliers 7a, 7b, 7c are movable along the first axis, for example by providing a rail and suitable brackets slidably mounted on the rail.

For support means with movable air multipliers 7a, 7b, 7c, the support means 6 may further comprise one or more electrically powered actuators configured to control movement of one or more of the air multipliers 7a, 7b, 7c along the first axis A.

The air multipliers 7a, 7b, 7c may be configured such that a discharge direction of each air multiplier 7a, 7b, 7c is parallel to the first axis, or at least essentially parallel to the first axis, such as within a range of 0-20 degrees, or within 0-15 or 0-10 degrees. It should be understood that the local direction of movement of surrounding air moved through the air multipliers (by the Coanda effect), is naturally different from the discharge direction, and naturally locally varies over the cross-section of the airflow generator 1.

The air multipliers 1 may be referred to as Coanda effect air multipliers 7a, 7b, 7c since they make use of the so called Coanda effect, which is known per-se.

Each air multiplier 7a, 7b, 7c of the fig. 3 and 4 embodiments forms a closed circular loop. Alternatively, any other shape of the air multipliers 7a, 7b, 7c is possible. For example, a square or rectangular shape, with or without rounded corners. Typically, the shape of the air multiplier is adapted to the intended shape and size of airflow needed. In other embodiments, the air multipliers 7a, 7b, 7c may alternatively be provided with one or two free ends, i.e. not a closed loop.

Since the air multipliers may be shaped from an extruded profile bent to its intended final shape, such a profile will be open ended and thus needs to be closed at any open ends to limit air leaks leading to undesired pressure-drop in the air multiplier 1. Normally, such open ends are capped with an end cap or closed in any other suitable way, such as with a plug. For example, a free end of an air multiplier having the cross-sectional shape shown in fig. 5, would have to be closed to enable air to be forced through the outlet opening 9 rather than through the open end.

Even if the air multiplier forms a closed loop, the outlet opening might not extend all the way around the closed loop, for example due to design limitations or simply to locally limit air output from the air multiplier 7a, 7b, 7c. Accordingly, the outlet of each air multiplier 7a, 7b, 7c may extends around at least 90% of a circumference of the air multiplier about the first axis A, such as around 100% of the circumference.

In the fig. 3 embodiment, the fluid conduit 5 is branched, with a separate branch connected to each one of the air multipliers 7a, 7b, 7c.

In the fig. 4 embodiment, the fluid conduit 5 is instead connected to one of the air multipliers 7a, 7b, 7c, and wherein the air multipliers 7a, 7b, 7c are fluidly interconnected by means of one or more additional fluid conduits 5b.

Any other configuration of the fluid conduit 5 able to route air from the ducted fan to the air multipliers 7a, 7b, 7c could alternatively be used instead, such as internal channels of a housing.

The airflow generator 1 of the present disclosure is especially useful for providing an airflow directed towards a heat exchanger mounted externally on a transformer 12. Accordingly, the present disclosure proposes to a transformer arrangement 10 schematically illustrated in fig. 6. The transformer arrangement 10 comprising an airflow generator 1 as described above, comprising a plurality of air multipliers 7a, 7b, 7c distributed along the first axis A. The transformer arrangement 10 further comprises a transformer 12 provided with an oil-to-air external heat exchanger 11. The airflow generator 1 is configured to discharge air towards the oil-to-air heat exchanger 11.

The oil-to-air external heat exchanger 11 is external in the sense that it is mounted externally on the transformer 10, thereby able to radiate and conduct heat to surrounding air. Typically, oil from inside the transformer 12 is pumped through the oil-to-air heat exchanger 11, wherein the oil transports heat generated within the transformer 12 out to the heat exchanger 11, such that the airflow from the airflow generator 1 cools the heat exchanger 11.

**Table of reference numerals**

| | |
|---|---|
| 1 | airflow generator |
| 2 | ducted fan |
| 3 | inlet of ducted fan |
| 4 | outlet of ducted fan |
| 5 | fluid conduit |
| 6 | support means |
| 7a, 7b, 7c | air multipliers |
| 8 | inlet of air multiplier |
| 9 | outlet of air multiplier |
| 10 | transformer arrangement |
| 11 | oil-to-air external heat exchanger |
| 12 | transformer |

## Claims

1. An airflow generator (1) comprising:
an electrically powered ducted fan (2) provided with an inlet (3) and an outlet (4),
a fluid conduit (5); and
a plurality of air multipliers (7a, 7b, 7c) for discharging air along a first axis (A), each air multiplier (7a, 7b, 7c) comprising an inlet (8) and an outlet (9),
said fluid conduit (5) fluidly connecting the outlet (4) of the ducted fan (2) to the inlets (8) of the air multipliers (7a, 7b, 7c),
wherein the air multipliers (7a, 7b, 7c) are distributed along the first axis (A),
**characterised in that** the air multipliers (7a, 7b, 7c) are differently sized to provide airflows of different cross-sectional size, and are positioned such that smaller ones (7b, 7c) of the air multipliers (7a, 7b, 7c) provide airflows reinforcing a respective sub-portion of the airflows provided by larger air multipliers (7a, 7b).

2. An airflow generator (1) according to claim 1, further comprising support means 6 configured to carry the air multipliers (7a, 7b, 7c), said support means 6 being configured such that at least some of the air multipliers (7a, 7b, 7c) are movable along the first axis (A).

3. An airflow generator (1) according to claim 2, wherein the support means 6 comprises one or more electrically powered actuators configured to control movement of one or more of the air multipliers (7a, 7b, 7c) along the first axis.

4. An airflow generator (1) according to any one of claims 1-3, wherein the air multipliers (7a, 7b, 7c) are configured such that a discharge direction of each air multiplier (7a, 7b, 7c) is parallel to the first axis (A).

5. An airflow generator according to any one of claims 1-4, wherein the air multipliers are Coanda effect air multipliers (7a, 7b, 7c).

6. An airflow generator according to any one of claims 1-5, wherein each air multiplier (7a, 7b, 7c) forms a closed loop.

7. An airflow generator according to claim 6, wherein the closed loops are circular.

8. An airflow generator (1) according to any one of claims 1-7, wherein the outlet of each air multiplier (7a, 7b, 7c) extends around at least 90% of a circumference of the air multiplier about the first axis (A), such as around 100% of the circumference.

9. An airflow generator (1) according to any one of claims 1-8, wherein the fluid conduit (5) is connected to one of the air multipliers (7a, 7b, 7c), and wherein the air multipliers (7a, 7b, 7c) are fluidly interconnected by means of one or more additional fluid conduits (5b).

10. A transformer arrangement (10) comprising an airflow generator (1) according to any one of claims 1-9, and a transformer provided with an oil-to-air external heat exchanger (11), said airflow generator (1) being configured to discharge air towards the oil-to-air heat exchanger (11).

## Patentansprüche

1. Luftstromerzeuger (1), der Folgendes umfasst:
ein elektrisch betriebenes Kanalgebläse (2), das mit einem Einlass (3) und einem Auslass (4) versehen ist,
eine Fluidleitung (5); und
mehrere Luftvervielfacher (7a, 7b, 7c) zum Ablassen von Luft entlang einer ersten Achse (A), wobei jeder Luftvervielfacher (7a, 7b, 7c) einen Einlass (8) und einen Auslass (9) umfasst,
wobei die Fluidleitung (5) den Auslass (4) des Kanalgebläses (2) fluidisch mit den Einlässen (8) der Luftvervielfacher (7a, 7b, 7c) verbindet,
wobei die Luftvervielfacher (7a, 7b, 7c) entlang der ersten Achse (A) verteilt sind, **dadurch gekennzeichnet, dass** die Luftvervielfacher (7a, 7b, 7c) unterschiedlich dimensioniert sind, um Luftströme mit unterschiedlicher Querschnittsgröße bereitzustellen, und so positioniert sind, dass kleinere (7b, 7c) der Luftvervielfacher (7a, 7b, 7c) Luftströme bereitstellen, die einen jeweiligen Unteranteil der durch die größeren Luftvervielfacher (7b, 7b) bereitgestellten Luftströme verstärken.

2. Luftstromerzeuger (1) nach Anspruch 1, der ferner Stützmittel 6 umfasst, die dazu ausgelegt sind, die Luftvervielfacher (7a, 7b, 7c) zu tragen, wobei die Stützmittel 6 so ausgelegt sind, dass mindestens einige der Luftvervielfacher (7a, 7b, 7c) entlang der ersten Achse (A) beweglich sind.

3. Luftstromerzeuger (1) nach Anspruch 2, wobei das Stützmittel 6 einen oder mehrere elektrisch angetriebene Aktuatoren umfasst, die dazu ausgelegt sind, die Bewegung eines oder mehrerer der Luftvervielfacher (7a, 7b, 7c) entlang der ersten Achse zu steuern.

4. Luftstromerzeuger (1) nach einem der Ansprüche 1-3, wobei die Luftvervielfacher (7a, 7b, 7c) so ausgelegt sind, dass eine Auslassrichtung jedes Luftvervielfachers (7a, 7b, 7c) parallel zu der ersten Achse (A) ist.

5. Luftstromerzeuger nach einem der Ansprüche 1-4, wobei die Luftvervielfacher Coand 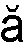 -Effekt-Luftvervielfacher (7a, 7b, 7c) sind.

6. Luftstromerzeuger nach einem der Ansprüche 1-5, wobei jeder Luftvervielfacher (7a, 7b, 7c) eine geschlossene Schleife bildet.

7. Luftstromerzeuger nach Anspruch 6, wobei die geschlossenen Schleifen kreisförmig sind.

8. Luftstromerzeuger (1) nach einem der Ansprüche 1-7, wobei sich der Auslass jedes Luftvervielfachers (7a, 7b, 7c) um mindestens 90 % eines Umfangs des Luftvervielfachers um die erste Achse (A) herum erstreckt, wie etwa um 100 % des Umfangs.

9. Luftstromerzeuger (1) nach einem der Ansprüche 1-8, wobei die Fluidleitung (5) mit einem der Luftvervielfacher (7a, 7b, 7c) verbunden ist und wobei die Luftvervielfacher (7a, 7b, 7c) mittels einer oder mehrerer zusätzlicher Fluidleitungen (5b) fluidisch miteinander verbunden sind.

10. Transformatoranordnung (10), die einen Luftstromerzeuger (1) nach einem der Ansprüche 1-9 und einen Transformator, der mit einem externen Öl-Luft-Wärmetauscher (11) versehen ist, umfasst, wobei der Luftstromerzeuger (1) dazu ausgelegt ist, Luft in Richtung des Öl-Luft-Wärmetauschers (11) abzugeben.

## Revendications

1. Générateur de flux d'air (1) comprenant :
une soufflante canalisée (2) alimentée électriquement munie d'une entrée (3) et d'une sortie (4),
un conduit de fluide (5) ; et
une pluralité de multiplicateurs d'air (7a, 7b, 7c) pour évacuer de l'air le long d'un premier axe (A), chaque multiplicateur d'air (7a, 7b, 7c) comprenant une entrée (8) et une sortie (9),
ledit conduit de fluide (5) connectant de manière fluidique la sortie (4) de la soufflante canalisée (2) aux entrées (8) des multiplicateurs d'air (7a, 7b, 7c),
les multiplicateurs d'air (7a, 7b, 7c) étant répartis le long du premier axe (A), **caractérisé en ce que** les multiplicateurs d'air (7a, 7b, 7c) sont dimensionnés différemment pour fournir des flux d'air de taille de section transversale différente, et sont positionnés de telle sorte que des multiplicateurs d'air plus petits (7b, 7c) parmi les multiplicateurs d'air (7a, 7b, 7c) fournissent des flux d'air renforçant une sous-partie respective des flux d'air fournis par des multiplicateurs d'air plus grands (7a, 7b).

2. Générateur de flux d'air (1) selon la revendication 1, comprenant en outre des moyens de support 6 configurés pour porter les multiplicateurs d'air (7a, 7b, 7c), lesdits moyens de support 6 étant configurés de telle sorte qu'au moins certains des multiplicateurs d'air (7a, 7b, 7c) soient mobiles le long du premier axe (A).

3. Générateur de flux d'air (1) selon la revendication 2, dans lequel les moyens de support 6 comprennent un ou plusieurs actionneurs alimentés électriquement configurés pour commander un déplacement d'un ou de plusieurs des multiplicateurs d'air (7a, 7b, 7c) le long du premier axe.

4. Générateur de flux d'air (1) selon l'une quelconque des revendications 1 à 3, dans lequel les multiplicateurs d'air (7a, 7b, 7c) sont configurés de telle sorte qu'une direction d'évacuation de chaque multiplicateur d'air (7a, 7b, 7c) soit parallèle au premier axe (A).

5. Générateur de flux d'air selon l'une quelconque des revendications 1 à 4, dans lequel les multiplicateurs d'air sont des multiplicateurs d'air (7a, 7b, 7c) à effet Coanda.

6. Générateur de flux d'air selon l'une quelconque des revendications 1 à 5, dans lequel chaque multiplicateur d'air (7a, 7b, 7c) forme une boucle fermée.

7. Générateur de flux d'air selon la revendication 6, dans lequel les boucles fermées sont circulaires.

8. Générateur de flux d'air (1) selon l'une quelconque des revendications 1 à 7, dans lequel la sortie de chaque multiplicateur d'air (7a, 7b, 7c) s'étend autour d'au moins 90 % d'une circonférence du multiplicateur d'air autour du premier axe (A), par exemple autour de 100 % de la circonférence.

9. Générateur de flux d'air (1) selon l'une quelconque des revendications 1 à 8, dans lequel le conduit de fluide (5) est connecté à l'un des multiplicateurs d'air (7a, 7b, 7c), et dans lequel les multiplicateurs d'air (7a, 7b, 7c) sont interconnectés de manière fluidique au moyen d'un ou de plusieurs conduits de fluide (5b) supplémentaires.

10. Agencement de transformateur (10) comprenant un générateur de flux d'air (1) selon l'une quelconque des revendications 1 à 9, et un transformateur pourvu d'un échangeur de chaleur externe huile-air (11), ledit générateur de flux d'air (1) étant configuré pour évacuer de l'air vers l'échangeur de chaleur huile-air (11).
